(19) Europäisches Patentamt
European Patent Office
Office européen des brevets

(11) **EP 2 854 294 B1**

(12) **EUROPEAN PATENT SPECIFICATION**

(45) Date of publication and mention
of the grant of the patent:
**30.03.2016 Bulletin 2016/13**

(51) Int Cl.:
**H03K 5/135** (2006.01)    **G06F 5/00** (2006.01)
**G06F 1/04** (2006.01)    **H03K 19/003** (2006.01)

(21) Application number: **13186719.4**

(22) Date of filing: **30.09.2013**

(54) **TEMPERATURE COMPENSATED TIMING SIGNAL GENERATOR**

TEMPERATURKOMPENSIERTER TAKTSIGNALGENERATOR

GÉNÉRATEUR DE SIGNAL DE SYNCHRONISATION À COMPENSATION DE TEMPÉRATURE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**01.04.2015 Bulletin 2015/14**

(73) Proprietor: **Micro Crystal AG
2540 Grenchen (CH)**

(72) Inventors:
• **Ruffieux, David
1789 Lugnorre (CH)**
• **Scolari, Nicola
1007 Lausanne (CH)**

(74) Representative: **Ravenel, Thierry Gérard Louis et al
ICB
Ingénieurs Conseils en Brevets SA
Faubourg de l'Hôpital 3
2001 Neuchâtel (CH)**

(56) References cited:
**EP-A1- 0 683 558    US-A- 5 644 271
US-A1- 2004 232 995**

**Description**

FIELD OF THE INVENTION

The present invention relates to temperature compensated timing signal generators. The invention more specifically concerns such timing signal generators in which pulse inhibition and/or pulse injection is used for compensating for variations of the temperature.

BACKGROUND OF THE INVENTION

Timing signal generators are known. They comprise an oscillator for providing a timing signal. The oscillator often comprises a quartz crystal resonator used to stabilize the oscillation frequency. While in principle quartz crystal oscillators are extremely accurate, it is known that their accuracy is detrimentally affected by temperature. A quartz crystal basically acts like a mechanical resonator, and any change in the temperature will cause it to expand or contract ever so slightly, thus changing the resonant frequency. In order to overcome the problems of variations in the resonant frequency, several approaches are known from the prior art.

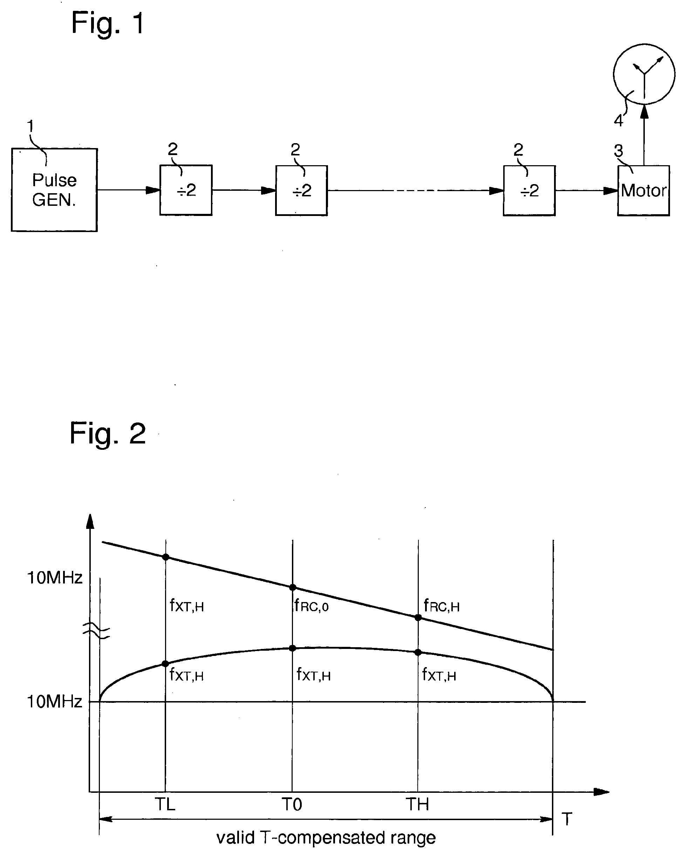

Figure 1 is a functional diagram of a prior art timepiece comprising a quartz crystal controlled oscillator 1, a series of binary dividers (flip-flops) 2 and a stepping motor 3 arranged to drive display means 4 of the timepiece in the form of watch-hands. In such a timepiece, the quartz crystal is often a 32'768 Hz quartz crystal tuning-fork resonator. 32'768 equals $2^{15}$. Accordingly, the dividing chain can comprise fifteen binary dividers, so that the output frequency of the chain is 1 Hz, suitable for driving the stepping motor 3.

32'768 Hz quartz crystal tuning-fork resonators are usually cut in such a way that when frequency is plotted over temperature, it defines a parabolic curve centered around 25 °C. In other words, a quartz crystal tuning-fork resonator will resonate close to its nominal frequency at room temperature, but will slow down when the temperature either increases or decreases from room temperature. A common parabolic coefficient for a 32'768 Hz tuning-fork resonator is -0.04 ppm/°C$^2$.

Timepieces equipped with a temperature sensor and capable of compensating for temperature changes are known. Patent document US 3,895,486 describes a temperature compensated time-keeping device, as well as a temperature compensation method. This particular method known as *inhibition compensation* is used to lower the frequency of a timing signal. For implementing this method, the quartz crystal resonator must deliberately be made to run somewhat fast. Pulse Inhibition compensation consists in having the division chain skip a small number of cycles at regular intervals such as 10 seconds or a minute. The number of cycles to skip each time depends on the temperature and is determined by means of a programed look-up table.

Another known method for compensating for temperature changes is *pulse injection compensation.* Contrarily to inhibition compensation, injection compensation works by increasing the frequency of a timing signal. As explained in patent documents US 3,978,650 and US 5,644,271A for example, injection compensation consists in incorporating (injecting) additional corrective pulses into the digital signal fed through the chain of binary dividers. Again, the number of pulses to inject is determined by means of a temperature sensor and a programed look-up table.

Both inhibition compensation and injection compensation are associated with a quantification error. The quantification error stems from the fact that it is not possible to add or suppress only a fraction of a pulse. Quantification limits the resolution to 1/f over 1 second when the frequency of the oscillator is f. If the oscillation frequency of the resonator is f=32768 Hz, the resolution is no better than 30.5 ppm, yielding an error of approximately $\pm$ 15 ppm. In order to obtain a resolution of 1 ppm for example, It is necessary to compensate over at least 1 million cycles. In the case of a 32768 Hz resonator, this implies waiting at least 31 seconds before applying inhibition or injection compensation. Accordingly, with this type of compensation, the frequency of the 1 Hz output from the chain of binary dividers 2 tends to deviate slightly from its nominal frequency up to the 30th pulse, and the accumulated error is compensated as a whole at the 31st pulse. This is not a problem with a watch, which is a time integrating instrument. However, in the case, for example, of a timing signal generator, the accuracy of each individual pulse should be better than 1 ppm. In this case, the temperature compensation methods described above are not satisfactory. It is therefore an object of the present invention to provide a signal generator in which each individual oscillation is thermally compensated.

SUMMARY OF THE INVENTION

The present invention achieves the object cited above by providing a temperature compensated timing signal generator in accordance with the annexed claim 1.

According to the invention, the temperature compensated timing signal generator implements inhibition compensation and/or injection compensation in order to provide a coarse thermal compensation of the duration of each time unit pulse, and the signal generator further implements "fractional inhibition" as a method of interpolation allowing to correct for the quantification error associated with the inhibition and/or injection compensation.

BRIEF DESCRIPTION OF THE DRAWINGS

Other features and advantages of the present invention will appear upon reading the following description, given solely by way of non-limiting example, and made with reference to the annexed drawings, in which:

- figure 1 is basic functional diagram of a prior art clock comprising a time base and a frequency divider, as well as a motor and time indicating means actuated by the frequency divider;
- figure 2 is a diagram showing temperature dependency of the frequencies of a quartz crystal tuning fork resonator and of a RC-oscillator;
- figure 3 is a basic functional block diagram illustrating a temperature compensated timing signal generator according to a particular embodiment of the present invention;
- figure 4 is a detailed functional block diagram illustrating an alternative implementation of the temperature compensated timing signal generator of figure 3;
- figure 5 is a timing diagram showing the effect of temperature compensation on the timing signal provided as output by the timing signal generator of Fig. 4.

DETAILED DESCRIPTION OF THE INVENTION

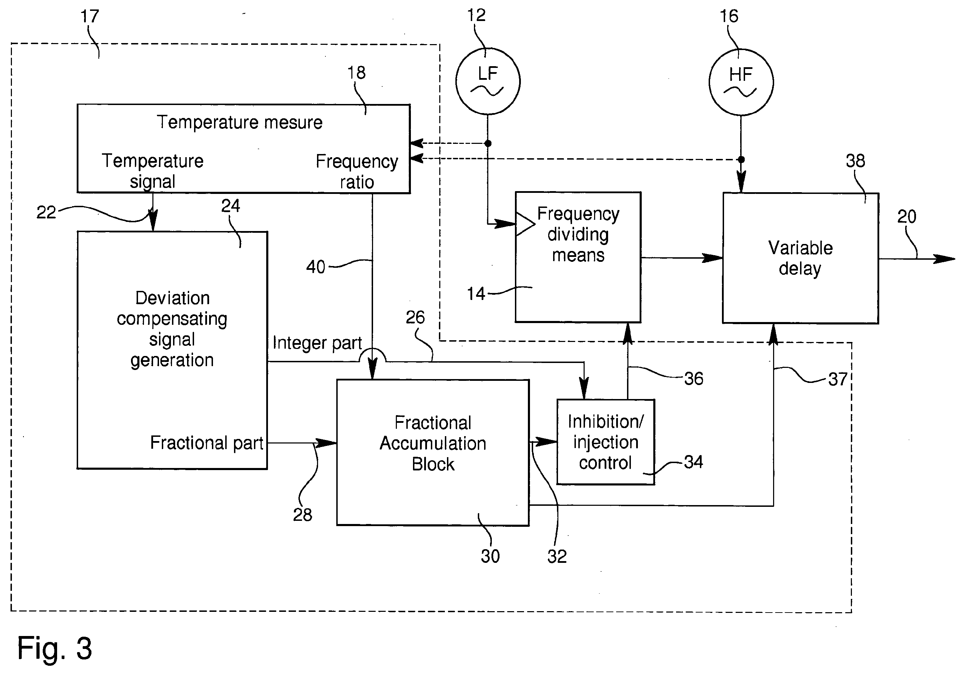

Fig. 3 is a block diagram illustrating a temperature compensated timing signal generator according to a first embodiment of the present invention. The timing signal generator of Fig. 3 is designed to provide a succession of temperature compensated time unit signal pulses through an output 20. The generator comprises a crystal oscillator 12 arranged to generate a reference time signal. The crystal oscillator can be based for example on a conventional 32.768 kHz quartz crystal tuning-fork resonator. The illustrated generator further comprises a frequency divider 14 arranged to count all the oscillations of the reference time signal, and to output one clock pulse for every 32'768 oscillations of the reference time signal from the crystal oscillator.

Still referring to Fig. 3, it can be observed that the temperature compensated timing signal generator of the present invention further comprises a high frequency oscillator 16. Oscillator 16 is arranged to provide a clock signal to a block 38 representing a variable delay. The variable delay 38 is provided for compensating variations in temperature by slightly delaying the onset of edges of the timing signal. Operation of this variable delay will be described further on. The high frequency oscillator is selected to have a frequency at least six orders of magnitude greater than the frequency of the temperature compensated timing signal provided by the generator. Preferably, the frequency of the high frequency oscillator is at least $10^7$ greater than the frequency of the temperature compensated timing signal. For example, if the target frequency for the temperature compensated timing signal is 1 Hz, then the high frequency oscillator can be a 1 MHz oscillator, or preferably a 10 MHz oscillator. For example, a 10 MHz RC-oscillator integrated on a chip.

The illustrated temperature compensated timing signal generator further comprises temperature compensating means identified as a whole by reference number 17. Referring again to Fig. 3, on can see that the temperature compensating means comprises a temperature measuring block 18 arranged to provide a signal representative of the temperature through an output 22, a deviation compensating signal generation block 24 arranged to receive the signal provided by block 18 and to provide as outputs both an integer and a fractional deviation compensation signal, a fraction accumulation block 30 arranged to receive the fractional deviation compensation signal through an input 28 and to add it to remainders from previous fractional deviation compensation signals in order to provide a fractional inhibition command signal through an output 37 to the variable delay 38, and finally an "inhibition/injection control" block 34 arranged to receive the integer deviation compensation signal through an input 26 and to provide an inhibition/injection command signal for the frequency dividing means 14 through an output 36.

In more details, the temperature measuring block 18 is connected to a temperature sensor thermally coupled to the crystal oscillator 12. The temperature sensor is arranged to measure the temperature of the crystal oscillator. The sensor can be of any type known to the person skilled in the art. For example, the temperature sensor can be a thermistor. The sensor can also be an oscillator, the frequency of which is sensitive to the temperature. More specifically, according to a particular embodiment, the temperature sensor comprises the high frequency oscillator 16. Block 18 is arranged to provide a temperature signal to block 24 through output 22. Block 24 has access to data relating to the frequency/temperature behavior of the crystal oscillator 12, and block 24 is arranged to use both this data and the temperature signal in order to provide a deviation compensating signal for compensating for temperature related deviations of the frequency of the crystal oscillator from a desired frequency. At least some of the above-mentioned frequency/temperature related data is recorded in nonvolatile memory contained in block 24. According to one embodiment, the deviation compensating signal generation block 24 contains a look-up table preloaded with deviation values corresponding to a selected temperature range. Based on a temperature signal received by block 24, the look-up table provides an integer deviation compensating signal through output 26 and a fractional deviation compensating signal through output 28.

In the particular case where the temperature compensated timing signal generator of the invention is arranged to provide a time unit signal, the time unit of which is equal to 1 second, the deviation compensating signal generated by block 24 preferably corresponds to the deviation of the frequency of the crystal oscillator 12 from a desired frequency. In the case where the temperature compensated timing signal generator of the invention is arranged to provide a time unit signal, the time unit of which is different from 1 second, the frequency of the reference time signal can advantageously be expressed as a number of oscillations per time unit, rather than as a number of oscillations per second. One should therefore understand that the deviation from the nominal frequency is preferably expressed as a number of oscillations of the crystal resonator 12. The deviation will be expressed as the combination of an integer number of oscillations of the crystal oscillator, and of a fractional rest corresponding to a remaining fraction of an oscillation of the crystal oscillator. This is the reason why the deviation compensating signal provided by the block 24 comprises both an integer part corresponding to an integer number of pulses of the crystal oscillator to be inhibited or injected into the frequency divider 14, and fractional part intended to compensate for any remaining deviation. One will further understand that, in the case where the frequency of the crystal oscillator is higher than the nominal frequency, the integer part of the deviation is to be compensated for by pulse inhibition and the fractional part by fractional inhibition. On the other hand, in the case where the frequency of the crystal oscillator is lower than the nominal frequency, the integer part of the deviation is to be compensated for by pulse injection, while the fractional part is always compensated for by fractional inhibition. Whether integer or fractional, inhibition can never increase the frequency of the timing signal. Therefore, in the case where the frequency of the crystal oscillator is lower than the nominal frequency, the integer number of pulses injected into the frequency divider should be large enough to increase the frequency of the timing signal up to at least the desired frequency. Fractional inhibition can then be used to slightly lower the frequency so as to remove any over compensation due to the quantification error. In other words, depending on whether the frequency of the crystal oscillator is higher or, on the contrary, lower than the nominal frequency, the integer part and the fractional part of the deviation compensating signal should be combined differently. In the first case, where the frequency of the crystal oscillator is higher than the nominal frequency, the deviation should preferably be expressed as the sum of an integer number of pulses to inhibit and of a fractional rest corresponding to fractional inhibition, while in the second case, where the frequency of the crystal oscillator is lower than the nominal frequency, the deviation is preferably expressed as an integer number of pulses from which a fractional rest is subtracted.

Block 24 is arranged to provide the integer part of the deviation compensating signal through output 26 and to provide the fractional part of the deviation compensating signal through output 28. During each pulse of the temperature compensated timing signal (provided through output 20), output 28 provides the fractional part of a new deviation compensating signal to fraction accumulation block 30. The fractional part of the new temperature compensating signal is added to the cumulative amount of fractions of deviation compensating signals already in the fraction accumulation block 30. Whenever the cumulative amount of fractions of the deviation compensating signal grows to over one period of the crystal oscillator 12, the accumulator overflows but the corresponding carry output is not accumulated. In this way, the accumulated fractional part of the deviation compensating signal contained in fraction accumulation block 30 always corresponds to less than one unit period of the crystal oscillator 12. The carry output is transferred through output 32 to the inhibition/injection control block 34, where it is added to the integer part of the deviation compensating signal in order to constitute the inhibition/injection command signal. One should understand however, that according to alternative embodiments of the invention, it would be possible to let the accumulated fractional part of the deviation compensating signal increase until it is equal to at least several periods of the crystal oscillator 12, before deducting these whole periods from the contents of the fraction accumulation block.

According to the invention, the accumulated fractional part of the deviation compensating signal is further converted into an equivalent number of periods of the high frequency oscillator 16. As the oscillation period of the high frequency oscillator 16 is many times smaller than the oscillation period of the crystal oscillator 12, the converted value of the accumulated fractional part of the deviation compensating signal almost always exceeds several periods of the high frequency oscillator. Therefore, the converted accumulated fractional part of deviation compensating signal can be rounded to an integer number periods of the high frequency oscillator without losing significantly on precision.

Expressing the accumulated fractional deviation compensating signal as an integer number of periods of the high frequency oscillator 16 requires knowing the relation between the frequencies of the two oscillators 12 and 16. Accordingly, the invention provides that the temperature compensating means 17 further comprise a frequency ratio determining circuit arranged to measure the ratio between the frequencies of crystal oscillator 12 and of high frequency oscillator 16. In the particular embodiment illustrated by the block diagram of Figure 3, the frequency ratio determining circuit is part of the temperature measuring block 18 and is provided to block 30 through output 40. Block 30 uses this ratio in order to convert the accumulated fractional deviation compensating signal, corresponding to a fraction of a period of the crystal oscillator 12, into a corresponding integer number of periods of the high frequency oscillator 16. The person skilled in art will understand that there are numerous ways in which the frequency ratio determining circuit can compute the frequency ratio. According to a particular embodiment, the circuit may determine the ratio between the frequencies of the crystal oscillator 12 and the high frequency oscillator 16 by counting the number of pulses from the high frequency oscillator within an oscillation period of the crystal oscillator.

The inhibition/injection control block 34 is arranged to correct the state of the frequency dividing means 14 once every period of the temperature compensated timing signal. It is known to the person skilled in the art that either inhibition or injection can provide temperature compensation. However, as explained in the introduction the temperature compensation obtained through inhibition or injection is coarse (i.e. has a limited resolution), and it is a goal of the present invention to allow for temperature compensation with a finer resolution. The present invention achieves this goal by further using the fractional part of the deviation compensating signal in order to control the variable delay 38 so as to implement a second finer temperature compensation.

According to the illustrated embodiment, variable delay 38 is, for example, a digital counter configured to receive the fractional inhibition command signal form fraction accumulation block 30 as input, and to count down to zero before generating an output signal. One should note that, on the one hand, the variable delay 38 is clocked by the high frequency oscillator 16, and that on the other hand, the fractional inhibition command signal is expressed as an integer number of periods of the high frequency oscillator 16. Therefore, one will understand that the illustrated embodiment of a temperature compensated timing signal generator according to the invention allows compensating for temperature up to a precision equal to a period of the high frequency oscillator 16. If for example the target frequency for the temperature compensated timing signal is 1 Hz, and the high frequency oscillator is a 1 MHz oscillator, then the frequency resolution will be 1 ppm.

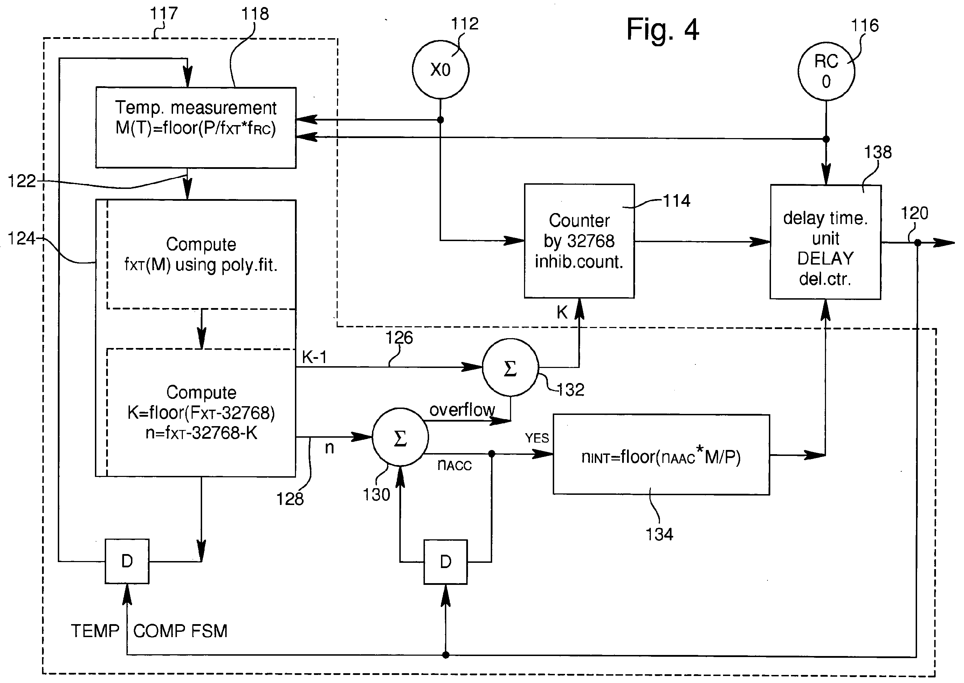

Fig. 4 is a functional block diagram illustrating a temperature compensated timing signal generator corresponding to an alternative implementation of the particular embodiment of the present invention shown in Fig. 3. According to this alternative implementation, the timing signal generator of the invention takes the form of an accurate 1 pulse per second timing signal generator. The generator of Fig. 4 is designed to provide a temperature compensated 1 Hz timing signal through an output 120. The generator comprises a 32.768 kHz crystal oscillator 112 based on a conventional quartz crystal tuning-fork resonator. The illustrated generator further comprises a counter 114 arranged to count all the oscillations from the crystal oscillator 112, and to output a clock pulse every time that it counts to 32'768 crystal oscillations. The counter is then reset for starting the next one second (i.e. 32.768) count. The timing signal generator further comprises a 10 MHz RC-oscillator 116. Oscillator 116 is arranged to provide a clock signal to a variable delay block 138. Variable delay block 138 is provided for compensating variations in temperature. Operation of the variable delay will be described further on.

The temperature compensated timing signal generator illustrated in Fig. 4 also comprises temperature compensating means identified as a whole by reference number 117. The illustrated temperature compensating means is made up mainly of functional blocks 118, 124, 130, 132 and 134. Functional block 118 receives the output signals from the crystal oscillator 112 and the RC-oscillator 116. Block 118 is arranged for counting a number (M) of pulses of the RC-oscillator 116 falling within a predetermined number (P) of oscillation periods of the crystal oscillator 112. For example, functional block 118 can be implemented with a pair of counters arranged to count the pulses from the two oscillators. As soon as one of the counters has counted P pulses from the crystal oscillator, the other counter stops counting the pulses from the RC-oscillator. The state of the second counter when it is stopped is the pulse count M. M is an integer that depends on the temperature (T) of the two oscillators. Functional block 118 is arranged to compute M(T) once every period of the temperature compensated timing signal. Therefore, a new value for the count M(T) is computed every second. Furthermore, the RC-oscillator 116 is in thermal contact with the crystal oscillator 112. Therefore, the two oscillators have the same temperature T.

Figure 2 is a diagram showing on the one hand a typical temperature dependency curve for the frequency $f_{XT}$ of a crystal oscillator comprising a quartz crystal tuning fork resonator, and on the other hand, a typical temperature dependency curve for the frequency $f_{RC}$ of a RC-oscillator. Although the horizontal and vertical scales of the diagram are not the same, in can be seen that the rate of variation with temperature of the frequency $f_{RC}$ of the RC-oscillator 116 is generally considerably larger than the rate of variation of the frequency $f_{XT}$ of the crystal oscillator 112. Furthermore, the variation of the frequency of an RC-oscillator with temperature is substantially linear. It follows that the oscillators can be chosen so that the relation between the count M(T) and the temperature T is univocal (unambiguous) within a predefined operating range. The count M(T) computed in functional block 118 can thus be used as a temperature signal. The pulse count M(T) can be computed with the following equation (1):

$$M(T) = floor(P * f_{RC} / f_{XT}); \qquad (1)$$

where the frequencies $f_{RC}$ and $f_{XT}$ both depend on the temperature T (the "floor" function used in the present application is defined in Wikipedia in the entry "floor and ceiling functions". This entry is incorporated by reference).

It is worthwhile to note that functional block 118 of Fig. 4 can be considered as a particular implementation of the temperature signal generation block 18 of Fig.3.

The temperature signal M(T) is provided to the deviation compensating signal generation block 124 through an output 122 of functional block 118. According to the illustrated example, the deviation compensating signal generation block 124 comprises a finite state machine configured with calibration data so as to provide a deviation compensating signal for any value of the temperature signal M(T) within a predefined operating range. Once calibrated, the finite state machine is capable of computing the deviation of the quartz crystal oscillator 112 (Deviation = $f_{XT}$ - 32'768) for any new value of M(T) within the operating range. Deviation compensating signal generation block 124 is arranged to provide a new deviation compensating signal once for every 1 Hz temperature compensated timing signal. In other words, a new value of the deviation compensating signal is provided for each new count M(T).

Configuring the finite state machine can be quite simple. Indeed, it is well known that the frequency-temperature behavior of tuning-fork quartz crystal resonators closely approximates a parabola. It follows that it is possible to predict the behavior of the crystal oscillator 112 with reasonably good accuracy by a simple second degree polynomial fit. The advantage of computing a polynomial fit instead of using a preloaded look-up table is that a polynomial fit requires preloading the values of temperature signal M(T) and of the frequency $f_{XT}(M)$ for only three different temperatures $T_L$, $T_0$ and $T_H$ (shown in Fig. 2).

It is important to note that, the deviation compensating signal generation block 124 computes not only the integer part of the frequency deviation (designated hereinafter by the letter "K"), but also computes a fractional component of the deviation (designated hereinafter by the letter "n"), up to a predefined number of fractional binary places. It follows that, in the case where $f_{XT}$ - 32'768 > 0, the total frequency deviation is equal to K + n, where 0 < n < 1. K and n can be computed with the two following equations (2) and (3) respectively:

$$K = \text{floor} \ (f_{XT} - 32'768) \qquad (2)$$

(and K is a positive integer or zero)

$$n = f_{XT} - 32'768 - K \qquad (3)$$

(0≤n<1)

Furthermore, in the case where $f_{XT}$ - 32'768 < 0, K and n can be computed with the two same equations:

$$K = \text{floor} \ (f_{XT} - 32'768) \qquad (2')$$

(however K is a negative integer)

$$n = f_{XT} - 32'768 - K \qquad (3')$$

(0≤n<1 is always true)
and the total frequency deviation is always equal to K + n (when K is negative, it means that pulse injection should be used instead of pulse inhibition).

As already explained in relation to Fig.3, n basically corresponds to a certain fraction of a period of the crystal oscillator during which the onset of a new pulse of the temperature compensated 1 Hz timing signal should be delayed in order to compensate for temperature. However, one will understand that if a particular pulse of the 1 Hz signal is delayed, the following pulses must also be delayed (or else the next pulse will be to short). Therefore, the delay should take into account both n and the value of the delay for the previous pulse. Still referring to Fig. 4, it can be seen that output 128 of block 124 is arranged to provide the fractional part n of a new deviation compensating signal to a functional block 130 representing an adder. In conjunction with a register (referenced D) made up of D flip-flops, functional block 130 works as an accumulator, in which the value n of the fractional part of the new deviation compensating signal is added to the value $n_{ACC}$ corresponding to the accumulation of previous fractional deviation compensating signals.

As previously mentioned in relation to Figure 3, whenever the cumulative amount of fractions of the deviation compensating signal grows to over one period of the crystal oscillator 12, the accumulator overflows but the corresponding carry output not accumulated.. One will therefore understand that functional block 130 operates in such a way that $n_{ACC}$ is always smaller than the duration of one period of the crystal oscillator 112. Furthermore, the carry output is immediately added as 1 additional unit to the integer part of the deviation compensating signal (K-1) by means of adder 132. In other words, whenever adder 130 overflows, 1 unit is added to the integer part of the deviation compensating signal so that its value is changed from K-1 to K.

Similarly to what was described in relation to the embodiment of Fig. 3, the accumulated fractional part of the deviation compensating signal is provided to functional block 134 from the output of adder 130. Functional block 134 converts $n_{ACC}$ into an equivalent number $n_{INT}$ of periods of the RC-oscillator 116. As the oscillation period corresponding to 10 MHz is many times smaller than the oscillation period corresponding to 32.768 kHz, the converted value $n_{INT}$ generally exceeds several periods of the RC-oscillator. Therefore, $n_{INT}$ can be rounded to an integer number periods without losing too much precision. "$n_{INT}$" can be computed with the following equation (4):

$$n_{INT} = \text{floor}\ (n_{ACC} {}^{*}M/P) \qquad\qquad (4)$$

where M is M(T) computed by functional block 118 and P is the number of oscillation periods of the crystal oscillator 112 over which M is counted. It follows that the ratio M/P corresponds to the length of one period of the crystal oscillator 112 expressed in units equal to the period of the RC-oscillator.

The integer part K-1 of a new deviation compensating signal is available for correcting the state of the frequency dividing means 114 once every period of the 1 Hz temperature compensated timing signal. According to the illustrated embodiment, the integer part K-1 of the deviation compensating signal corresponds to the number of 32.768 kHz pulses of the crystal oscillator 112 that should be inhibited or injected during a particular period of the 1 Hz temperature compensated timing signal. As explained in the introduction, pulse inhibition compensation, like pulse injection compensation, can provide a resolution of no better than 30.5 ppm. As previously explained, in order to achieve a resolution as good as 1 ppm, the present invention also uses the fractional part of the deviation compensating signal n in order to control the variable delay 138 so as to implement a second level of temperature compensation with a much finer resolution.

As in the previous example, variable delay 138 can be, for example, a digital counter clocked by the RC-oscillator 116 and configured to receive the fractional inhibition command signal $n_{INT}$ provided by the functional block 134. As $N_{INT}$ is expressed in units equal to the oscillation period of the RC-oscillator, the variable delay 138 allows for compensating for temperature up to a precision equal to a period of the 10 MHz RC-oscillator, that is $10^{-7}$ seconds.

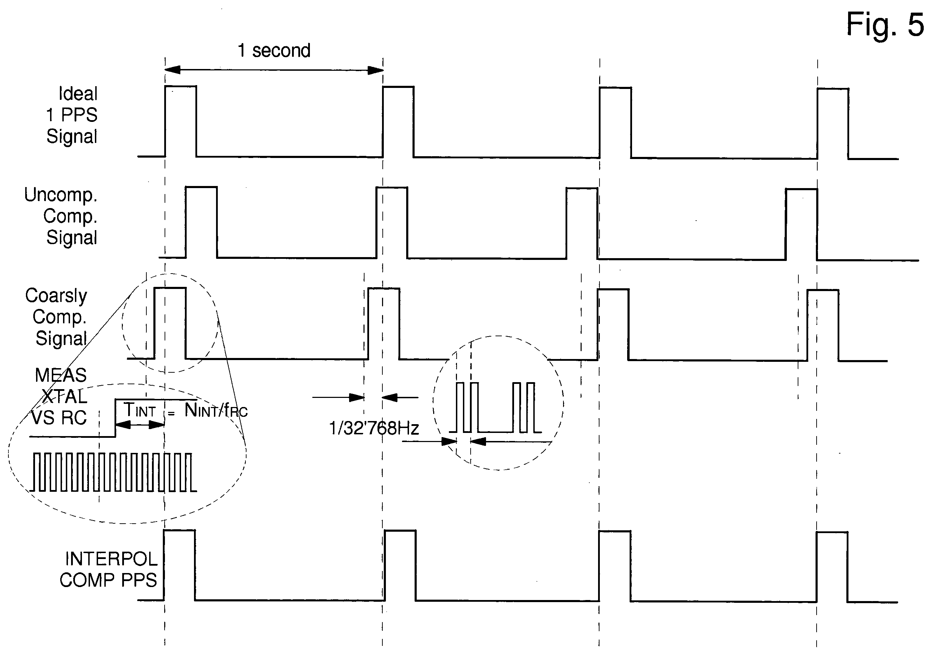

Fig. 5 is a timing diagram showing the effect of temperature compensation on the timing signal provided as output by the timing signal generator of Fig. 4. Referring to Fig. 5, the first line shows an ideal 1 pulse per second (1 pps) signal that might be produced by a perfectly compensated timing signal generator. The ascending edges of the ideal pulses shown in the figure are labeled i1, i2, i3 and i4 respectively. The double headed arrow situated between edges i1 and i2 represents the oscillation period T (1 second in the example).

The second line of Fig. 5 shows the actual pulses that would be delivered by functional block 114 of Fig. 4 in the absence of any temperature compensation. The frequency of the uncompensated signal of line 2 is equal to the frequency of the crystal oscillator 112 divided by 32'768. As can be seen, the uncompensated signal deviates markedly from the ideal signal. This deviation is generally due partly to the way the resonator was made, and partly to variations in the ambient temperature. As can be seen in Fig. 5, the uncompensated signal is actually fast compared to the ideal signal.

Line 3 of Fig. 5 shows the actual pulses that are delivered by functional block 114 when pulse inhibition is used for a coarse temperature compensation. Coarse temperature compensation by pulse inhibition as shown on the third line is known. Pulse inhibition has the effect of lowering the frequency, thus bringing the frequency closer to the ideal frequency. However, pulse inhibition can only delay the onset of the next pulse by multiples of the oscillation period of the crystal oscillator; that is approximately 1/32'768 Hz, or in other words, 31 $\mu$s. The resolution is therefore about 30 ppm.

Line 4 of Fig. 5 shows the temperature compensated timing signal delivered by the timing signal generator of Fig. 4. As can be observed, the temperature compensated timing signal is almost perfectly synchronized with the ideal 1 pps signal of the first line. The variable delay is capable of delaying the onset of the next pulse with a resolution equal to the oscillation period of the RC-oscillator; that is approximately $1/10^7$ s., or in other words, 0.1 $\mu$s. The resolution is therefore about 0.1 ppm.

One advantage of the described temperature compensated timing signal generator is that it can have a very low energy consumption. Indeed, except for the high frequency oscillator, the components of the timing signal generator require very little power. Therefore, according to a preferred embodiment of the invention, in order to save energy, the high frequency oscillator is shut down for the major part of each time unit, and is turned on only when it is needed.

More specifically, applying this way of doing to the particular example illustrated in Figure 4, it can be observed that when an oscillator like the 10 MHz RC-oscillator 116 of Figure 4 is turned on, it needs approximately 120 $\mu$s for the frequency to stabilize. Once the oscillations have stabilized, the operation of counting the number of pulses M(T) of the RC-oscillator during P periods of the crystal oscillator is typically carried out during about 1'000 $\mu$s. Finally, implementing the fractional inhibition requires only a handful of periods of the RC-oscillator. The RC-oscillator therefore typically operates for 1.1 milliseconds during every second. This corresponds to a duty cycle of approximately 1/900. Power consumption of the RC-oscillator can thus be reduced in the same proportion.

Having described the invention with regard to certain specific embodiments, it is to be understood that these embodiments are not meant as limitations of the invention. Indeed, various modifications, adaptations and/or combination between embodiments may become apparent to those skilled in the art without departing from the scope of the annexed claims. In particular, the temperature signal provided by block 18 to block 24 (Fig. 3) need not be based on the ratio between the frequencies of crystal oscillator 12 and of high frequency oscillator 16. The temperature signal could just as well be based on the difference between the frequencies of the crystal oscillator 12 and of the high frequency oscillator 16. This difference can be obtained for example by mixing the reference time signal and the interpolation signal.

Finally, one should understand that it is not a problem if the high frequency oscillator of Fig. 3 or the RC-oscillator of Fig. 4 have deviated substantially from its nominal frequency. Indeed, the frequency ratio M/P is updated regularly, preferably once during each period of the temperature compensated timing signal.

**Claims**

1. A temperature compensated timing signal generator for generating a succession of temperature compensated time unit signal pulses, said time unit being an arbitrary predefined time interval, the timing signal generator comprising:

   a crystal oscillator (12; 112) configured to generate a reference time signal, and a divider circuit (14, 114) arranged to receive the reference time signal as input and to output a coarse time unit signal, the reference time signal and the coarse time unit signal each having an actual frequency deviating from a corresponding desired frequency as a function of the temperature of said crystal oscillator;
   a high frequency oscillator (16; 116) configured to generate an interpolation signal having an actual frequency ($f_{RC}$) greater than the actual frequency ($f_{XT}$) of the crystal oscillator;
   a temperature signal generation circuit (18; 118) comprising a temperature sensor in thermal contact with the crystal oscillator (12; 112) and configured to provide and refresh periodically a digital temperature signal representative of the temperature of said crystal oscillator;
   a finite state machine (24; 124) configured with calibration data so as to compute for each time unit signal pulse, as a function of the digital temperature signal (M(T)), a deviation compensating signal comprising an integer part (K-1) representative of an integer number of pulses to be inhibited or injected in the divider circuit (14; 114) and a fractional part (n) representative of how much the output of a new time unit signal pulse should further be delayed in order to compensate for any remaining deviation;
   a coarse compensation circuit (34; 126) arranged to receive the integer part (K-1) of each new deviation compensating signal and for injecting or inhibiting a number of pulses of the reference time signal in the divider circuit (14; 114) for each time unit signal pulse, said number of pulses depending on said integer part of the deviation compensating signal; **characterized by**
   a fraction accumulation circuit (30; 130, D) arranged to receive, for each time unit signal pulse, a new fractional part (n) of the deviation compensating signal, and to compute iteratively a new accumulated fractional deviation compensating signal ($n_{ACC}$) by adding said new one of said fractional parts (n) of the deviation compensating signal to the previous accumulated fractional deviation compensating signal,
   a scale conversion circuit (24, 40; 118, 124) arranged to provide and refresh periodically a digital frequency ratio signal (M/P) representative of the ratio ($f_{RC}/f_{XT}$) of the frequency of the high frequency oscillator (16; 116) over the frequency of the crystal oscillator (12; 112), and further arranged for generating a fractional inhibition command signal ($n_{INT}$) by converting the accumulated deviation compensating signal ($n_{ACC}$) into a corresponding number of periods of the interpolation signal;
   a variable delay circuit (38, 138) arranged to receive each new fractional inhibition command signal ($n_{INT}$) and to delay the output of the next time unit signal pulse for the duration of a corresponding number of periods of the interpolation signal.

2. The temperature compensated timing signal generator of claim 1, wherein the actual frequency ($f_{RC}$) of the high frequency oscillator (16; 116) is sensitive to temperature, and the high frequency oscillator is in thermal contact with the crystal oscillator (12; 112), and wherein the temperature signal generator (18; 118) is arranged to receive as input the interpolation signal and is configured to compute a digital temperature signal M(T), the digital temperature signal being representative of the temperature (T).

3. The temperature compensated timing signal generator of claim 2, wherein, the temperature signal generator (18; 118) also receives the reference time signal as input, and is configured to compute the digital temperature signal (M(T)) on the basis of the ratio ($f_{RC}/f_{XT}$) of the actual frequency of the high frequency oscillator (16; 116) over the actual frequency of the crystal oscillator (12; 112).

4. The temperature compensated timing signal generator of any one of claims 1, 2 and 3, wherein, the integer part (K-1) of the deviation compensating signal is derived from the value (K) corresponding to the largest integer smaller than the frequency deviation (K = floor ($f_{XTactual}$ - $f_{XTdesired}$)), and the fractional part (n) of the deviation compensating signal is equal to the fractional part of the frequency deviation (n = $f_{XTactual}$ - $f_{XTdesired}$ - K).

5. The temperature compensated timing signal generator of any one of the preceding claims, wherein, if said new accumulated fractional deviation compensating signal ($n_{ACC}$) equals no less than one period of the crystal oscillator (112), then one period of the crystal oscillator is deducted from said new fractional inhibition command signal and one unit is added to the integer part (K-1) of the deviation compensating signal.

6. The temperature compensated timing signal generator of any one of the preceding claims, wherein, the high frequency oscillator (16; 116) has a frequency ($f_{RC}$) at least $10^6$ times as great as the frequency of the temperature compensated time unit signal pulses.

7. The temperature compensated timing signal generator of any one of the preceding claims, wherein the crystal oscillator comprises a 32'768 Hz tuning-fork quartz crystal resonator.

8. The temperature compensated timing signal generator of any one of the preceding claims, wherein the high frequency oscillator is a RC-oscillator having a monotonous frequency dependency on temperature, and wherein an average temperature coefficient of the RC-oscillator is at least one order of magnitude greater than an average of the modulus of the temperature coefficient of the first oscillator in the same operating temperature range.

9. The temperature compensated timing signal generator of any one of the preceding claims, wherein the interpolation signal generated by the RC-oscillator has a frequency of about 10 MHz at room temperature.

10. The temperature compensated timing signal generator of claim 3, wherein the temperature signal generator is configured to compute the digital temperature signal representative of the temperature, by counting how many pulses of the interpolation signal fall within a first time interval corresponding to a predetermined number of pulses of the reference time signal.

**Patentansprüche**

1. Temperaturkompensierter Taktsignalerzeuger zum Erzeugen einer Folge von temperaturkompensierten Zeiteinheitssignalimpulsen, wobei die Zeiteinheit ein willkürlich vorgegebenes Zeitintervall ist, wobei der Taktsignalerzeuger umfasst:

einen Kristalloszillator (12; 112), der konfiguriert ist, ein Referenzzeitsignal zu erzeugen, und eine Teilerschaltung (14, 114), die ausgelegt ist, das Referenzzeitsignal als Eingabe zu empfangen und ein grobes Zeiteinheitssignal auszugeben, wobei das Referenzzeitsignal und das grobe Zeiteinheitssignal jeweils eine tatsächliche Frequenz haben, die von einer entsprechenden gewünschten Frequenz als eine Funktion der Temperatur des Kristalloszillators abweicht;
einen Hochfrequenzoszillator (16; 116), der konfiguriert ist, ein Interpolationssignal mit einer tatsächlichen Frequenz ($f_{RC}$), die größer als die tatsächliche Frequenz ($f_{XT}$) des Kristalloszillators ist, zu erzeugen;
eine Temperatursignalerzeugungsschaltung (18; 118), die einen Temperatursensor in thermischem Kontakt mit dem Kristalloszillator (12; 112) umfasst und konfiguriert ist, ein digitales Temperatursignal, das die Temperatur des Kristalloszillators repräsentiert, bereitzustellen und periodisch zu aktualisieren;
einen endlichen Zustandsautomaten (24; 124), der mit Kalibrierungsdaten konfiguriert ist, um für jeden Zeiteinheitsimpuls als eine Funktion des digitalen Temperatursignals (M(T)) ein Abweichungskompensationssignal zu berechnen, das einen ganzzahligen Teil (K - 1), der eine ganzzahlige Anzahl von Impulsen, die zu unterdrücken oder in die Teilerschaltung (14; 114) einzuspeisen sind, repräsentiert, und einen Bruchteil (n), der repräsentiert, wie viel die Ausgabe eines neuen Zeiteinheitssignalimpulses weiter verzögert werden sollte, um eine restliche Abweichung zu kompensieren, umfasst;
eine Grobkompensationsschaltung (34; 126), die ausgelegt ist, den ganzzahligen Teil (K - 1) eines jeden neuen Abweichungskompensationssignals zu empfangen und zum Einspeisen oder Unterdrücken einer Anzahl von Impulsen des Referenzzeitsignals in der Teilerschaltung (14; 114) für jeden Zeiteinheitssignalimpuls, wobei die Anzahl der Impulse von dem ganzzahligen Teil des Abweichungskompensationssignals abhängt;

**gekennzeichnet durch**:

eine Bruchakkumulationsschaltung (30; 130, D), die ausgelegt ist, für jeden Zeiteinheitssignalimpuls einen neuen Bruchteil (n) des Abweichungskompensationssignals zu empfangen und iterativ ein neues akkumuliertes Bruchabweichungskompensationssignal ($n_{ACC}$) **durch** Hinzufügen des neuen Bruchteils (n) des Abweichungskompensationssignals zu dem vorher akkumulierten Bruchabweichungskompensationssignal zu berechnen, eine Skalenumsetzungsschaltung (24, 40; 118, 124), die ausgelegt ist, ein digitales Frequenzverhältnissignal (M/P), das das Verhältnis ($f_{RC}/f_{XT}$) der Frequenz des Hochfrequenzoszillators (16; 116) zu der Frequenz des Kristalloszillators (12; 112) repräsentiert, bereitzustellen und periodisch zu aktualisieren, und ferner ausgelegt ist, ein Bruchunterdrückungsbefehlssignal ($n_{INT}$) **durch** Umsetzen des akkumulierten Abweichungskompensationssignals ($n_{ACC}$) in eine entsprechende Anzahl von Perioden des Interpolationssignals zu erzeugen; eine Schaltung einer variablen Verzögerung (38, 138), die ausgelegt ist, jedes neue Bruchunterdrückungsbefehlssignal ($n_{INT}$) zu empfangen und die Ausgabe des nächsten Zeiteinheitssignalimpulses für die Dauer einer entsprechenden Anzahl von Perioden des Interpolationssignals zu verzögern.

2. Temperaturkompensierter Taktsignalerzeuger nach Anspruch 1, wobei die tatsächliche Frequenz ($f_{RC}$) des Hochfrequenzoszillators (16; 116) auf die Temperatur empfindlich reagiert und der Hochfrequenzoszillator in thermischem Kontakt mit dem Kristalloszillator (12; 112) ist und wobei der Temperatursignalerzeuger (18; 118) ausgelegt ist, als Eingabe das Interpolationssignal zu empfangen, und konfiguriert ist, ein digitales Temperatursignal (M(T)) zu berechnen, wobei das digitale Temperatursignal die Temperatur (T) repräsentiert.

3. Temperaturkompensierter Taktsignalerzeuger nach Anspruch 2, wobei der Temperatursignalerzeuger (18; 118) auch das Referenzzeitsignal als Eingabe empfängt und konfiguriert ist, das digitale Temperatursignal (M(T)) auf der Basis des Verhältnisses ($f_{RC}/f_{XT}$) der tatsächlichen Frequenz des Hochfrequenzoszillators (16; 116) zu der tatsächlichen Frequenz des Kristalloszillators (12; 112) zu berechnen.

4. Temperaturkompensierter Taktsignalerzeuger nach einem der Ansprüche 1, 2 und 3, wobei der ganzzahlige Teil (K-1) des Abweichungskompensationssignals von dem Wert (K), der die größte ganze Zahl, die kleiner als die Frequenzabweichung (K = floor($f_{XTtatsächlich}$ - $f_{XTgewünscht}$)) ist, abgeleitet wird und der Bruchteil (n) des Abweichungskompensationssignals gleich dem Bruchteil der Frequenzabweichung (n = $f_{XTtatsächlich}$ - $f_{XTgewünscht}$ - K) ist.

5. Temperaturkompensierter Taktsignalerzeuger nach einem der vorhergehenden Ansprüche, wobei dann, wenn das neue akkumulierte Bruchabweichungskompensationssignal ($n_{ACC}$) nicht kleiner als eine Periode des Kristalloszillators (112) ist, eine Periode des Kristalloszillators von dem neuen Bruchunterdrückungsbefehlssignal abgezogen wird und eine Einheit zu dem ganzzahligen Teil (K - 1) des Abweichungskompensationssignals hinzugefügt wird.

6. Temperaturkompensierter Taktsignalerzeuger nach einem der vorhergehenden Ansprüche, wobei der Hochfrequenzoszillator (16; 116) eine Frequenz ($f_{RC}$) besitzt, die mindestens $10^6$ mal so groß wie die Frequenz des temperaturkompensierten Zeiteinheitssignalimpulses ist.

7. Temperaturkompensierter Taktsignalerzeuger nach einem der vorhergehenden Ansprüche, wobei der Kristalloszillator einen 32,768 Hz-Stimmgabel-Quarzkristallresonator umfasst.

8. Temperaturkompensierter Taktsignalerzeuger nach einem der vorhergehenden Ansprüche, wobei der Hochfrequenzoszillator ein RC-Oszillator mit einer monotonen Frequenzabhängigkeit von der Temperatur ist und wobei ein mittlerer Temperaturkoeffizient des RC-Oszillators mindestens eine Größenordnung größer als ein Mittelwert des Moduls des Temperaturkoeffizienten des ersten Oszillators in demselben Betriebstemperaturbereich ist.

9. Temperaturkompensierter Taktsignalerzeuger nach einem der vorhergehenden Ansprüche, wobei das durch den RC-Oszillator erzeugte Interpolationssignal eine Frequenz von ungefähr 10 MHz bei Raumtemperatur besitzt.

10. Temperaturkompensierter Taktsignalerzeuger nach Anspruch 3, wobei der Temperatursignalerzeuger konfiguriert ist, das digitale Temperatursignal, das die Temperatur repräsentiert, durch Zählen, wie viele Impulse des Interpolationssignals in ein erstes Zeitintervall fallen, das einer vorgegebenen Anzahl von Impulsen des Referenzzeitsignals entspricht, zu berechnen.

**Revendications**

1. Générateur thermo-compensé de signaux d'horloge pour produire une succession d'impulsions d'un signal temporel unitaire compensées en température, l'unité de temps pour le signal temporel unitaire étant un intervalle arbitraire prédéfini, le générateur de signaux d'horloge comportant :

    un oscillateur à cristal (12 ; 112) configuré pour produire un signal temporel de référence, et un circuit diviseur (14 ; 114) agencé pour recevoir le signal temporel de référence en entrée et pour fournir en sortie un signal temporel unitaire grossier, le signal temporel de référence et le signal temporel unitaire grossier ayant chacun une fréquence effective qui présente avec une fréquence désirée correspondante un écart qui est fonction de la température du dit oscillateur à cristal ;

    un oscillateur haute-fréquence (16 ; 116) configuré pour produire un signal d'interpolation ayant une fréquence effective ($f_{RC}$) supérieure à la fréquence effective ($f_{XT}$) de l'oscillateur à cristal ;

    un circuit générateur d'un signal de température (18 ; 118) comportant un capteur de température en contact thermique avec l'oscillateur à cristal (12; 112) et configuré pour fournir et pour rafraichir périodiquement un signal numérique de température représentatif de la température du dit oscillateur à cristal ;

    un automate fini (24 ; 124) configuré à l'aide de données de calibration de manière à calculer, pour chaque impulsion du signal temporel unitaire, en fonction du signal numérique de température (M(T)), un signal de compensation de l'écart comprenant une partie entière (K-1) représentative d'un nombre entier d'impulsions à inhiber ou à injecter dans le circuit diviseur (14; 114) et une partie fractionnaire (n) représentative d'une durée pendant laquelle il faut encore retarder la production d'une nouvelle impulsion du signal temporel unitaire, de manière à compenser un éventuel écart résiduel ;

    un circuit de compensation grossière (34 ; 126) agencé pour recevoir la partie entière (K-1) de chaque nouveau signal de compensation de l'écart, et pour injecter ou inhiber dans le circuit diviseur (14, 114), pour chaque impulsion du signal temporel unitaire, un nombre d'impulsions du signal temporel de référence, ledit nombre d'impulsions dépendant de ladite partie entière du signal de compensation de l'écart ;

    **caractérisé en ce qu'**il comporte en outre :

    un circuit d'accumulation des parties fractionnaires (30 ; 130, D) agencé pour recevoir, pour chaque impulsion du signal temporel unitaire, une nouvelle partie fractionnaire (n) du signal de compensation de l'écart, et pour calculer itérativement un nouveau signal fractionnaire accumulé de compensation de l'écart ($n_{ACC}$) par ajout de ladite nouvelle partie fractionnaire (n) du signal de compensation de l'écart au précédent signal fractionnaire accumulé de compensation de l'écart ;

    un circuit de conversion d'échelle (24, 40; 118, 124) agencé pour fournir et pour rafraichir périodiquement un signal numérique de rapport de fréquence (M/P) représentatif du rapport ($f_{RC}/f_{XT}$) entre la fréquence de l'oscillateur haute-fréquence (16 ; 116) et la fréquence de l'oscillateur à cristal (12 ; 112), et agencé en outre pour produire un signal de commande d'inhibition fractionnaire ($n_{INT}$) en convertissant le signal fractionnaire accumulé de compensation de l'écart ($n_{ACC}$) en un nombre correspondant de périodes du signal d'interpolation ;

    un circuit de retard variable (38 ; 138) agencé pour recevoir chaque nouveau signal de commande d'inhibition fractionnaire ($n_{INT}$) et pour différer la production de la prochaine impulsion du signal temporel unitaire d'un nombre correspondant de périodes du signal d'interpolation.

2. Générateur thermo-compensé de signaux d'horloge conforme à la revendication 1, dans lequel la fréquence effective ($f_{RC}$) de l'oscillateur haute-fréquence (16; 116) est sensible à la température, l'oscillateur haute-fréquence étant en contact thermique avec l'oscillateur à cristal (12; 112), et dans lequel le circuit générateur du signal de température (18; 118) est agencé pour recevoir le signal d'interpolation en entrée et est configuré pour calculer un signal numérique de température M(T), le signal numérique de température étant représentatif de la température (T).

3. Générateur thermo-compensé de signaux d'horloge conforme à la revendication 2, dans lequel le circuit générateur du signal de température (18 ; 118) reçoit également en entrée le signal temporel de référence, et est configuré pour calculer le signal numérique de température M(T) sur la base du rapport ($f_{RC}/f_{XT}$) de la fréquence effective de l'oscillateur haute-fréquence (16 ; 116) sur la fréquence effective de l'oscillateur à cristal (12 ; 112).

4. Générateur thermo-compensé de signaux d'horloge conforme à l'une quelconque des revendications 1, 2 et 3, dans lequel la partie entière (K-1) du signal de compensation de l'écart est tirée de la valeur (K) qui correspond au plus grand nombre entier inférieur à l'écart de fréquence (K = floor($f_{XTreffective}$ - $f_{XTdésirée}$)), et la partie fractionnaire (n) du signal de compensation de l'écart est égale à la partie fractionnaire de l'écart (n = $f_{XTeffective}$ - $f_{XTdésirée}$ - K).

**5.** Générateur thermo-compensé de signaux d'horloge conforme à l'une quelconque des revendications précédentes, dans lequel, si ledit nouveau signal fractionnaire accumulé de compensation de l'écart ($n_{ACC}$) est égal à au moins une période de l'oscillateur à cristal (112), on soustrait une période de l'oscillateur à cristal du dit nouveau signal de commande d'inhibition fractionnaire et on ajoute une unité à la partie entière (K-1) du signal de compensation de l'écart.

**6.** Générateur thermo-compensé de signaux d'horloge conforme à l'une quelconque des revendications précédentes, dans lequel l'oscillateur haute-fréquence (16 ; 116) a une fréquence ($f_{RC}$) au moins $10^6$ fois plus grande que la fréquence des impulsions compensées en température du signal temporel unitaire.

**7.** Générateur thermo-compensé de signaux d'horloge conforme à l'une quelconque des revendications précédentes, dans lequel l'oscillateur à cristal comporte un résonateur à diapason en cristal de quartz à 32'768 Hz.

**8.** Générateur thermo-compensé de signaux d'horloge conforme à l'une quelconque des revendications précédentes, dans lequel l'oscillateur haute-fréquence est un oscillateur RC dont la fréquence est une fonction monotone de la température, et dans lequel un coefficient de température moyen de l'oscillateur RC est supérieur d'au moins un ordre de grandeur à une moyenne de la valeur absolue du coefficient de température du premier oscillateur dans le même intervalle de fonctionnement en température.

**9.** Générateur thermo-compensé de signaux d'horloge conforme à l'une quelconque des revendications précédentes, dans lequel le signal d'interpolation produit par l'oscillateur RC a une fréquence d'environ 10 MHz à température ambiante.

**10.** Générateur thermo-compensé de signaux d'horloge conforme à la revendication 3, dans lequel le générateur du signal de température est configuré pour calculer le signal numérique de température représentatif de la température, en comptant les impulsions du signal d'interpolation produites durant un premier intervalle temporel qui correspond à un nombre prédéfini d'impulsions du signal temporel de référence.

# Fig. 1

# Fig. 2

valid T-compensated range

Fig. 3

EP 2 854 294 B1

Fig. 4

117 118

112 X0

116 RC 0

Temp. measurement
M(T)=floor(P/f$_{XT}$*f$_{RC}$)

122

124

Compute
f$_{XT}$(M) using poly.fit.

Compute
K=floor(F$_{XT}$-32768)
n=f$_{XT}$-32768-K

114

Counter
by 32768
inhib.count.

138

delay time.
unit
DELAY
del.ctr.

120

K

126 K-1

$\Sigma$

132

overflow

128 n

130

$\Sigma$

n$_{ACC}$

YES

n$_{INT}$=floor(n$_{AAC}$*M/P)

134

D

D

TEMP | COMP FSM

EP 2 854 294 B1

15

Fig. 5

1 second

Ideal
1 PPS
Signal

Uncomp.
Comp.
Signal

Coarsly
Comp.
Signal

MEAS
XTAL
VS RC

$T_{INT} = N_{INT}/f_{RC}$

1/32'768Hz

INTERPOL
COMP PPS

EP 2 854 294 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3895486 A
- US 3978650 A
- US 5644271 A